# EUROPEAN PATENT APPLICATION

(11) **EP 0 604 810 A2**
(43) Date of publication of application: **06.07.1994**
(21) Application number: 93120027.3
(22) Date of filing: 11.12.1993
(51) Int. Cl.: G01R 33/04

(54) **Internal stress relaxation method in magnetic field sensor head cores**

(30) Priority: 31.12.1992 ES 9202668
(71) Applicant: ALCATEL STANDARD ELECTRICA, S.A., E-28045 Madrid (ES)
(72) Inventor: Aroca Hernandez-Ros, Claudio, E-28008 Madrid (ES); Sanchez Trujillo, Carmen, E-28220 Majadahonda Madrid (ES); Lopez Perez, Eloisa, E-28003 Madrid (ES); Sanchez Sanchez, Pedro, E-28043 Madrid (ES)
(74) Representative: Pohl, Herbert, Dipl.-Ing

(57) **Abstract**

Applicable in the manufacturing process in magnetic field sensor head cores (1) comprising a core of amorphous ferromagnetic material on which is placed directly a first winding that forms the drive coil, and which also includes a second and third windings that constitute the sensor and compensating coils, respectively, both wound over a cylinder inside which is located the assembly formed by the core and the drive coil.

A first electric current (2) is applied to the core of this sensor head (1) , which heats up due to its electrical losses.

In addition, a second alternating electric current (3) is applied to one of the coils that surrounds the core and which acts as a magnetizing coil; an analysis (4) is made of the signal induced in another of the coils that surround the core and that acts as detector coil and, finally, a decision (5) is taken on the process ending (6) when the level of the signal induced in the detector coil falls down significantly.

## Description

### OBJECT OF THE INVENTION

This invention concerns a method for relaxing internal stress produced in the core of a high sensitivity magnetometric sensor during the operation of coil winding, where the primary or drive winding is wound directly on the core of amorphous ferromagnetic material covered only by a strip of insulating tape.

This method is applicable to the process of manufacturing high sensitivity magnetometric sensor heads of the flux-gate type.

### BACKGROUND TO THE INVENTION

The use of magnetometric sensors based on the flux-gate principle has been known from the 1950s and, since then, although the basic principle has not changed, great effort has been dedicated to perfecting these devices, especially with respect to noise reduction and boosting sensitivity.

In the article "Sensor noise in low-level flux-gate magnetometers", by D.C. Scouten, published in the IEEE Transactions on Magnetics review, volume MAG-8 No.2, June 1972, page 228, it is shown how noise sources are produced through non-alignments in the structure of the core material and that their effect is equivalent to independent magnetic moments that occur inside the core. These non-alignments can be produced, and in fact are produced, by mechanical stress, including direct winding on the core, during the manufacturing process of the sensor head.

In the article "An evaluation of the noise performance of Fe, Co, Si and B amorphous alloys in ring-core fluxgate magnetometers" by B.B. Narod et al., published by CAN. J. PHYS., volume 63, 1985, on page 1472 it is indicated how major improvements can be achieved in relation to noise characteristics by means of sophisticated methods of core annealing.

At present, the most standard procedure is annealing the unwound core in an oven at a temperature above the Curie temperature, at which the internal stress relax and the nonalignments that produce desoriented magnetic couples disappear, thereby significantly reducing the noise produced by the core in question. The high temperatures normally reached prevent annealing of the core once wound, since the wire of the enveloping winding could be damaged, unless a special, and much more expensive wire is employed.

For this reason it is chosen to wind the coils on cylinders that can stand the winding forces and the following manufacturing processes, instead of these having to be supported directly by the core itself.

This means that more electromagnetic energy would be required in order to saturate the core with subsequent increase in power consumption.

### TECHNICAL PROBLEM TO BE OVERCAME

The technical problem to be overcame rests in how to perform the annealing of the core of amorphous ferromagnetic material of a magnetometric sensor head at a temperature sufficient to relax the core stress, without there being any effect on the drive coil winding when directly wound on the core in question, because of high temperatures.

### CHARACTERIZATION OF THE INVENTION

The problem above mentioned is resolved by application of the method of the invention, which permits the relaxation of the internal stress in the core material by means of annealing only the core, respecting the drive coil wound directly on it.

As has already been stated, the magnetometric sensor head consists of a core of amorphous ferromagnetic material on which is wound directly a first winding that forms the drive coil and which is insulated from this core or subsequent envoltures by means of insulating tape only in order to maintain high sensitivity. The sensor head also has a second winding, or sensor coil, and a third winding, or compensating coil, both of which are wound on a cylinder, into which is inserted the assembly comprising the core and the drive coil, to protect this assembly from the high stress produced by these last two windings because of their high number of turns.

To proceed to the heating and subsequent annealing of the core, an electric current is made to pass through it, so that the inherent electrical losses in the core material produce a heating effect up to a certain temperature that is not directly controllable and which it is desirable should be greater than the Curie temperature, at which a disorientation of the magnetic dipoles occurs, consequently reducing the noise of the core material in a significant manner.

To determine this temperature, a second alternating current is caused to flow through one of the windings, for example that of the compensating coil, generating thereby a magnetic field of sufficient strength in the core. At the same time, a signal is picked up in the sensor coil produced by the processes of core magnetization.

Once the core temperature has reached the Curie temperature, the signal picked up by the sensor coil falls down abruptly, in this way demonstrating that the core annealing process has been completed for the relaxation or reduction of core stress, through the release of internal stress in the constituent material.

### BRIEF FOOTNOTES TO THE FIGURES

A more detailed explanation of the invention can be found in the following description of the invention, based in the accompanying figures in which:
- figure 1 shows the configuration of the magnetometric sensor with compensating coil of the type referred to in this invention,
- figure 2 shows a flowchart of the annealing method for relaxing the stresses in the core material, in accordance with the invention, and
- figure 3 shows the composition of a high sensitivity sensor head in the core of which major internal stresses have been formed during the manufacturing process and that have to be relaxed using a method such as that of the invention.

### DESCRIPTION OF THE INVENTION

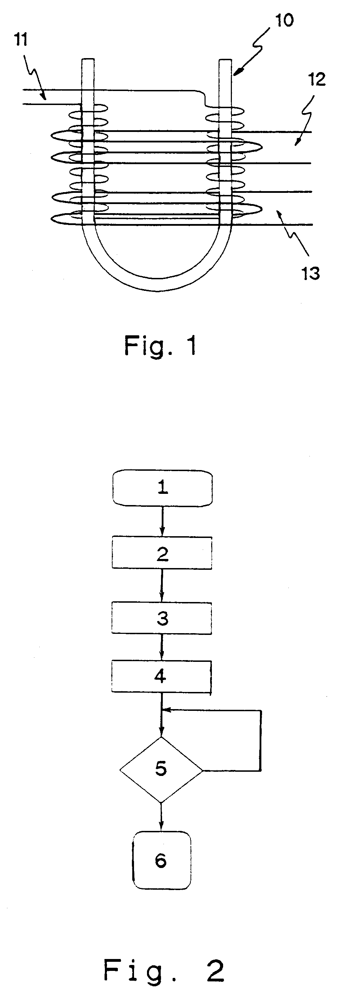

A magnetometric sensor of the flux-gate type has the basic configuration shown in figure 1, in which, on a core 10 of an amorphous ferromagnetic material, is wound a drive coil 11 to which is applied an alternating signal at a determined frequency that saturates the core 10 symmetrically.

There is another sensor coil 12 into which is coupled part of the magnetic field existing in the core, in such a way that it is possible to measure the external magnetic fields acting on the core 10 as a result of the asymmetry produced in the hysteresis curve.

Finally there is a third compensating coil 13 that serves to generate a constant magnetic field inside the core 10 in order to cancel the magnetic field of the earth or of other nearby sources that are present in a fixed manner and that interfere with the field that it is actually desired to detect.

The method of the invention is explained in the application on a physical implementation of a sensor head of this type as can be seen in figure 3, in which a core 31 of amorphous ferromagnetic material is covered with a teflon tape 33 on which is subsequently wound the winding of the drive coil, that is again covered with a teflon tape. The assembly is bent in the middle in order to form a structure equivalent to that of a ring.

Both of the processes mentioned, winding and bending, produce stresses in the core material, giving rise to a core 31 that generates a lot of noise, and which has a response that is not very linear and a reduced dynamic range. The sensor head formed in this way, is not suitable for oven-annealing as the drive coil could be damaged due to the high temperatures.

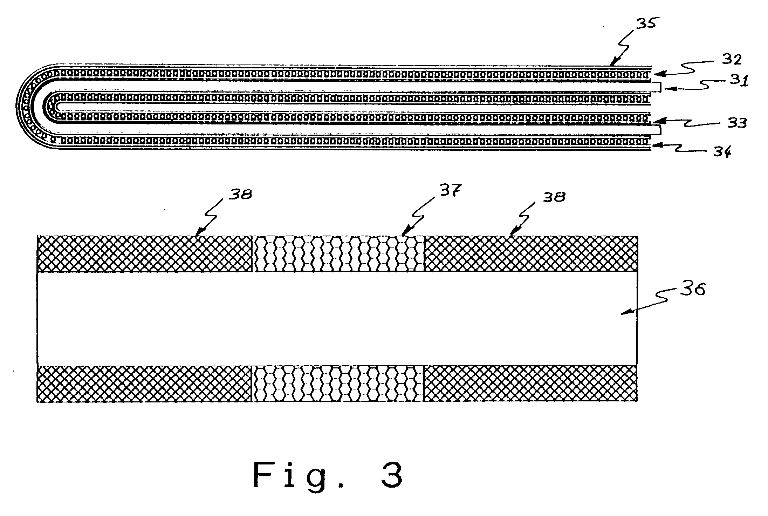

The assembly so formed is carefully fitted into a cylinder 36, on top of which have been wound both the sensor coil 37 and the compensating coil 38. Once the magnetometric sensor head 1 has been completed, annealing of the core of this head takes place by means of the method of this invention as indicated in the diagram shown in figure 2. To start with, a first electric current is applied 2 to the core 31 in order to heat it as a result of its inherent electrical losses. In addition, a second alternating electric current is applied 3 to the winding of the compensating coil 38, creating a magnetic field in the core 31 of the sensor head, such that, when the signal obtained in the sensor coil 37 due to the magnetization of the core is cancelled, it means that the Curie temperature has been exceeded and consequently the internal stresses have been relaxed, at which point the process has been concluded.

## Claims

1. **INTERNAL STRESS RELAXATION METHOD IN MAGNETIC FIELD SENSOR HEAD CORES** consisting of a core (31) of amorphous ferromagnetic material onto which is directly wound a first winding that constitutes the drive coil (32) separated from this core (31) and from subsequent envoltures by means of corresponding insulating tapes (33), that also includes a second winding forming the sensor coil (37) and a third winding forming the compensating coil (38), that are wound on a cylinder (36) into which is inserted the assembly formed by the core (31) and the drive coil (32) and **characterized** in that it comprises the following stages:
- application of an electric current (2) to the core (31) of the amorphous ferromagnetic material which heats up due to its inherent electrical losses,
- application of a second alternating electric current (3) via the winding of one of the coils surrounding the core, that acts as the magnetizer of the core (31),
- analysis (4) of the signal induced in another of the coils that surrounds the core (31) and that acts as detector of the magnetic field created inside this core (31), and
- decision (5) on the process ending (6) that implies the cancellation of the previous currents when the signal induced in the coil that acts as the magnetic field detector drops significantly in level, the internal stress relaxation then occurring in the material of the core (31).
